# FASCICULE DE BREVET EUROPEEN

(11) **EP 3 173 375 B1**
(45) Date de publication et mention de la délivrance du brevet: **14.11.2018**
(21) Numéro de dépôt: 16200506.0
(22) Date de dépôt: 24.11.2016
(51) Int. Cl.: B81C 1/00

(54) **PROCEDE D'ENCAPSULATION D'UN DISPOSITIF MICROELECTRONIQUE AVEC UN TROU DE LIBERATION DE DIMENSION VARIABLE**
EINKAPSELUNGSVERFAHREN EINER MIKROELEKTRONISCHEN VORRICHTUNG MIT EINEM AUSLASSLOCH VARIABLER GRÖSSE
METHOD FOR PACKAGING A MICROELECTRONIC DEVICE WITH A RELEASE HOLE HAVING A VARIABLE SIZE

(30) Priorité: 27.11.2015 FR 1561474
(43) Date de publication de la demande: 31.05.2017
(73) Titulaire: COMMISSARIAT À L'ÉNERGIE ATOMIQUE ET AUX ÉNERGIES ALTERNATIVES, 75015 Paris (FR)
(72) Inventeur: PORNIN, Jean-Louis, 38920 CROLLES (FR); BAILLIN, Xavier, 38920 CROLLES (FR)
(74) Mandataire: Brevalex

(56) Documents cités:
- US-A1- 2014 147 955

## Description

### DOMAINE TECHNIQUE ET ART ANTÉRIEUR

L'invention se rapporte au domaine de la microélectronique, et plus particulièrement à celui de l'encapsulation de dispositifs microélectroniques par exemple de type MEMS (microsystèmes électromécaniques) et/ou NEMS (nanosystèmes électromécaniques) et/ou MOEMS (microsystèmes opto-électromécaniques) et/ou NOEMS (nanosystèmes opto-électromécaniques).

L'invention concerne notamment un procédé d'encapsulation de type Packaging Couche Mince (PCM).

L'intégration des dispositifs microélectroniques par exemple de type MEMS ou NEMS dans le monde industriel ou dans les outils de la vie courante est de plus en plus fréquente, avec une demande de miniaturisation et de réduction des coûts de plus en plus forte. Cette intégration passe par une étape de packaging qui sert à protéger le dispositif microélectronique et à assurer sa fonctionnalité tout au long de sa durée de vie, tout en tenant compte des contraintes auxquelles le dispositif est soumis : vibrations, changements de température, sensibilité à certains gaz, etc.

Un tel packaging peut être réalisé par une encapsulation en couche mince, également appelée Packaging Couche Mince ou PCM, ou « Thin-Film Packaging » ou TFP en anglais. Ce procédé consiste à réaliser au-dessus du dispositif microélectronique une capsule protectrice disposée au plus près de la partie active du dispositif, en utilisant les techniques de la microélectronique. Une telle encapsulation est avantageusement mise en oeuvre de manière collective pour plusieurs dispositifs microélectroniques réalisés sur un même substrat : on parle alors de packaging à l'échelle du substrat, ou WLP pour « Wafer Level Packaging ».

Le procédé PCM consiste tout d'abord à déposer et localiser un matériau sacrificiel au-dessus du dispositif microélectronique à protéger. Une couche d'encapsulation, généralement de type minérale, est ensuite déposée sur ce matériau sacrificiel. Des trous de libération sont ensuite réalisés à travers la couche d'encapsulation pour permettre l'élimination du matériau sacrificiel, principalement par gravure sèche. Cette élimination du matériau sacrificiel est aussi appelée étape de libération du dispositif microélectronique, et forme la cavité dans laquelle est disposé le dispositif microélectronique. Le procédé est ensuite achevé en bouchant les trous de libération de façon à fermer la cavité, avantageusement de manière hermétique. Ce bouchage est obtenu en déposant des couches de bouchage soit par évaporation (procédé de type PVD, PECVD, etc.) d'une ou plusieurs couches métalliques ou minérales, soit par enduction centrifuge ou « spin coating » de polymère.

La difficulté de mise en oeuvre de cette étape de bouchage des trous de libération consiste à ne pas déposer de matériau de bouchage à l'intérieur de la cavité, ce qui pourrait nuire sinon au bon fonctionnement du dispositif microélectronique. Le diamètre et le nombre de trous de libération sont donc définis de façon à trouver un compromis entre un temps de libération court, obtenu en réalisant les trous de libération avec le plus grand diamètre possible, et la facilité de bouchage, obtenue en réalisant les trous de libération avec le plus petit diamètre possible.

Afin de s'affranchir de ce compromis, plusieurs solutions ont été proposées.

Le document FR 2 948 928 A1 décrit une structure d'encapsulation d'un dispositif microélectronique dont le capot est muni d'un clapet disposé en regard d'un trou de libération qui traverse le capot. Le clapet peut boucher ou non le trou selon la température à laquelle le clapet est soumis, du fait que ce clapet comporte deux portions de matériaux de coefficients de dilatation thermique différents. Ce clapet est en position ouverte pour l'étape de libération du dispositif microélectronique, puis est amené en position fermé sous le trou de libération pendant l'étape de bouchage. Le trou de libération peut ainsi être réalisé avec un diamètre important puisque lors du dépôt du matériau de bouchage, celui-ci se déposera à l'intérieur du trou en prenant appui sur le clapet qui ferme l'accès à l'intérieur de la cavité.

Le document FR 2 864 340 A1 décrit également une structure d'encapsulation comportant un clapet formé sur le capot.

Le document US 2015/0266718 A1 décrit un procédé dans lequel des trous de libération de différentes dimensions sont réalisés à travers le capot. Des trous de faibles dimensions sont réalisés au-dessus de la partie active du dispositif microélectronique et un trou de grande dimension est réalisé au-dessus d'une partie non sensible du dispositif microélectronique. Les trous de faibles dimensions sont bouchés en mettant en oeuvre un premier dépôt n'engendrant pas de dépôt gênant de matériau de bouchage sur le dispositif microélectronique.

Ce premier dépôt ne permet toutefois pas de boucher le trou de grandes dimensions. Le bouchage du trou de grande dimension est ensuite réalisé en utilisant un procédé de dépôt à plus haute pression, qui induit un dépôt important de matériau de bouchage sur le dispositif microélectronique. Toutefois, du fait que le trou de grande dimension est localisé au-dessus d'une partie non sensible du dispositif microélectronique, ce dépôt du matériau de bouchage dans la cavité n'est pas pénalisant pour le fonctionnement du dispositif microélectronique. Ce procédé permet d'obtenir des cavités fermées sous une pression plus importante qu'avec le procédé précédemment décrit faisant appel au clapet d'obturation.

Le document US 2008/0079142 A1 décrit la réalisation d'un capot formé de deux couches espacées l'une de l'autre et percées chacune de trous de libération. Les trous de libération formés à travers chacune des couches ne se superposent pas, formant ainsi un réseau de chicanes entre l'extérieur et l'intérieur de la cavité. La couche du capot la plus proche du dispositif microélectronique sert donc de couche protectrice par rapport au matériau de bouchage.

Le principal inconvénient commun à tous les procédés décrits ci-dessus est qu'ils nécessitent la mise en oeuvre d'étapes supplémentaires, notamment de photolithographie et gravure, par rapport à un procédé d'encapsulation classique. Or, ces étapes supplémentaires ont un impact important sur le coût final du dispositif encapsulé.

Un autre inconvénient lié au bouchage de trous de grandes dimensions est que, sauf à ajouter encore des étapes supplémentaires de dépôt visant à réduire la taille de ces trous préalablement au bouchage, le dépôt du matériau de bouchage, par exemple type SACVD ou PECVD, se fait à une pression relativement élevée (quelques centaines de mT) et en présence de précurseurs chimiques. Or, cela est incompatible avec une encapsulation du dispositif microélectronique à basse pression et/ou sous une atmosphère inerte.

### EXPOSÉ DE L'INVENTION

Un but de la présente invention est de proposer un procédé d'encapsulation d'un dispositif microélectronique s'affranchissant du compromis relatif aux dimensions des trous de libération, qui ne nécessite pas la mise en oeuvre d'étapes supplémentaires lors de l'encapsulation par rapport à une procédé d'encapsulation classique, et qui soit compatible avec un encapsulation à basse pression et/ou sous une atmosphère inerte.

Pour cela, la présente invention propose un procédé d'encapsulation d'au moins un dispositif microélectronique, comportant au moins les étapes suivantes :
- réalisation d'au moins une portion de matériau sacrificiel recouvrant au moins le dispositif microélectronique ;
- réalisation d'au moins un capot recouvrant au moins la portion de matériau sacrificiel, le capot comportant au moins deux couches superposées de matériaux distincts et ayant des contraintes résiduelles différentes et/ou des coefficients de dilatation thermique différents ;
- gravure, à travers le capot, d'au moins une tranchée dont le motif, au niveau d'une face supérieure du capot, comporte au moins une courbe et/ou au moins deux segments droits non parallèles l'un par rapport à l'autre et se rejoignant en un point d'intersection ;
- gravure de la portion de matériau sacrificiel à travers la tranchée telle que, lors de cette gravure, une portion du capot définie par la tranchée se déforme sous l'effet d'une contrainte mécanique engendrée par les contraintes résiduelles et/ou une dilatation thermique desdites au moins deux couches du capot et augmente les dimensions de la tranchée ;
- suppression au moins partielle de la contrainte mécanique, obtenue soit en retirant au moins une partie d'une deuxième desdites au moins deux couches du capot qui est telle qu'une première des deux couches du capot soit disposée entre la portion de matériau sacrificiel et la deuxième des deux couches du capot, soit en arrêtant de soumettre lesdites au moins deux couches du capot à une température engendrant la déformation de la portion du capot;
- dépôt d'au moins un matériau de bouchage au moins sur la tranchée.

Ce procédé utilise judicieusement les propriétés mécaniques et/ou thermomécaniques des matériaux utilisés pour former le capot pour s'affranchir du compromis relatif aux dimensions des trous de libération qui doit être réalisés dans les procédés de l'art antérieur. En effet, la tranchée particulière réalisée définie une portion du capot formant une languette apte à se déformer lors de la gravure de la portion de matériau sacrificiel sous l'effet des contraintes résiduelles et/ou de la dilatation thermique des matériaux du capot. Ainsi, lors de la gravure de la portion de matériau sacrificiel, la tranchée forme un trou de libération de dimension importante, permettant de réaliser rapidement la gravure du matériau sacrificiel et donc la libération du dispositif microélectronique. A la fin de cette gravure, la languette retrouve sa position initiale, ou une position proche de sa position initiale, du fait de la suppression au moins partielle de la contrainte mécanique à l'origine de la déformation de cette languette. La tranchée retrouve alors également des dimensions inférieures à celles lorsque la languette est déformée, ce qui permet de réaliser ensuite le bouchage de la tranchée sans risque de dépôt du matériau de bouchage dans la cavité d'encapsulation.

En outre, du fait que le capot est directement formé à partir des matériaux ayant des contraintes résiduelles différentes et/ou des coefficients de dilatation thermique différents, aucune mise en forme particulière n'est nécessaire pour définir la portion du capot qui se déforme lors de la gravure du matériau sacrificiel. La tranchée peut être gravée en une seule étape de photolithographie et gravure, même si le capot comporte plusieurs couches. En termes de nombre d'étapes mises en oeuvre, étant donné que la gravure de la tranchée correspond à l'étape de réalisation du trou de libération, ce procédé peut comporter un nombre d'étapes (notamment de photolithographie et gravure) similaire aux procédés d'encapsulation classiques.

Enfin, du fait que la contrainte mécanique déformant la portion du capot est supprimée au moins partiellement avant le dépôt du matériau de bouchage, ce qui signifie que la tranchée retrouve ses dimensions initiales ou des dimensions proches de ses dimensions initiales, ou au moins des dimensions inférieures à celles lorsque la languette est déformée, le dépôt du matériau de bouchage peut se faire sans avoir à faire appel à des hautes pressions et/ou des précurseurs chimiques particuliers. Le procédé selon l'invention est donc compatible avec une encapsulation à basse pression, par exemple comprise entre environ 10 Pa et 10⁵ Pa et/ou sous une atmosphère inerte, par exemple via un dépôt PVD.

Avant le dépôt du matériau de bouchage, la contrainte mécanique est au moins partiellement supprimée. Lors du dépôt du matériau de bouchage, une contrainte résiduelle peut être tolérée si elle engendre une déformation n'empêchant pas le bouchage.

Lorsque la portion du capot n'est pas déformée, une largeur de la tranchée, correspondant à la plus petite dimension de la tranchée au niveau de la face supérieure du capot, peut être de l'ordre du micron, ou comprise entre environ 1 µm et 2 µm. En outre, la déformation de la portion du capot peut être telle que cette largeur de la tranchée soit comprise entre environ 4 µm et 10 µm lorsque la portion du capot est déformée.

La suppression de la contrainte mécanique peut être obtenue soit en retirant au moins une partie de la deuxième couche du capot, soit en arrêtant de soumettre les couches du capot à la température engendrant la déformation de la portion du capot.

Lors de la gravure de la portion de matériau sacrificiel, la déformation de la portion du capot peut être telle qu'une extrémité libre de la portion du capot se déplace hors de la cavité, c'est-à-dire vers l'extérieur de la cavité. En variante, cette déformation peut être telle que l'extrémité libre de la portion du capot se déplace vers l'intérieur de la cavité.

Une première des deux couches du capot disposée entre la portion de matériau sacrificiel et une deuxième des deux couches du capot peut comporter une contrainte résiduelle de valeur et/ou de type (compression ou tension) différent de la contrainte résiduelle de la deuxième des deux couches du capot.

De manière avantageuse, la première des deux couches du capot peut comporter une contrainte résiduelle en compression et la deuxième des deux couches du capot peut comporter une contrainte résiduelle en tension.

Ainsi, lorsque la portion du capot est libérée du matériau sacrificiel, la portion du capot peut être soumise à une contrainte résiduelle globale qui peut avantageusement déformer la portion du capot telle que l'extrémité libre de la portion se déplace hors de la cavité.

Selon une variante, les deux couches du capot peuvent comporter chacune une contrainte résiduelle en compression. Dans ce cas, pour que l'extrémité libre de la portion du capot se déplace hors de la cavité lors de la gravure de la portion de matériau sacrificiel, la contrainte résiduelle en compression de la deuxième couche peut être inférieure à celle de la première couche.

Selon une autre variante, les deux couches du capot peuvent comporter chacune une contrainte résiduelle en tension. Dans ce cas, pour que l'extrémité libre de la portion du capot se déplace hors de la cavité lors de la gravure de la portion de matériau sacrificiel, la contrainte résiduelle en tension de la deuxième couche peut être supérieure à celle de la première couche.

Selon une autre variante, la première des deux couches du capot peut comporter une contrainte résiduelle en tension et la deuxième des deux couches du capot peut comporter une contrainte résiduelle en compression. Dans ce cas, lors de la gravure de la portion de matériau sacrificiel, l'extrémité libre de la portion du capot se déplace vers l'intérieur de la cavité.

La première des deux couches du capot peut comporter du SiO₂ et la deuxième des deux couches du capot peut comporter du nickel. Cette configuration peut permettre l'obtention de contraintes résiduelles en compression et en tension respectivement dans la première couche et dans la deuxième couche.

La deuxième des deux couches du capot peut comporter un empilement d'une sous-couche comprenant du titane recouvrant la première des deux couches du capot et d'une couche de nickel recouvrant la sous-couche. Une telle sous-couche de titane a pour avantage d'améliorer l'adhésion de la deuxième des deux couches du capot sur la première des deux couches du capot.

La suppression au moins partielle de la contrainte mécanique déformant la portion du capot peut comporter la mise en oeuvre d'un retrait d'au moins une partie de la deuxième des deux couches du capot. Cette étape de retrait permet de faire reprendre à la portion du capot une position sensiblement non-déformée lorsque la déformation de la portion du capot est engendrée par les contraintes résiduelles de la deuxième des deux couches du capot. Lorsque la deuxième couche du capot comporte du nickel, cette étape de retrait peut notamment consister à retirer ce nickel.

Une première des deux couches du capot, disposée entre la portion de matériau sacrificiel et une deuxième des deux couches du capot, peut comporter un coefficient de dilatation thermique supérieur à celui de la deuxième des deux couches du capot, et la gravure de la portion de matériau sacrificiel peut être mise en oeuvre à une température engendrant une déformation de la portion du capot due à la dilatation thermique des deux couches.

Pour obtenir une telle dilatation thermique, la première des deux couches du capot peut comporter de l'aluminium et la deuxième des deux couches du capot peut comporter du titane.

La suppression au moins partielle de la contrainte mécanique déformant la portion du capot peut dans ce cas consister à arrêter la soumission des couches du capot à la température engendrant une déformation de la portion du capot due à la dilatation thermique des deux couches.

Le dépôt du matériau de bouchage peut être mis en oeuvre à température ambiante, ce qui supprime la contrainte mécanique déformant la portion du capot lorsque cette déformation est due à la dilatation thermique des deux couches qui ont des coefficients de dilatation thermique différents.

L'étape de gravure de la tranchée à travers le capot peut graver également des trous à travers le capot et pouvant avoir au moins une dimension (cette dimension étant par exemple le diamètre dans le cas d'un trou de section circulaire, ou la dimension d'un côté dans le cas d'un trou de section polygonale) sensiblement similaire à une largeur de la tranchée. De tels trous peuvent ainsi contribuer à accélérer encore plus la gravure de la portion de matériau sacrificiel.

De manière avantageuse, les trous peuvent traverser la portion du capot se déformant lors de la gravure de la portion de matériau sacrificiel. Ainsi, les trous contribuent à aboutir plus rapidement à la déformation de la portion du capot.

Le capot peut comporter en outre au moins une couche supplémentaire à travers laquelle au moins la tranchée est gravée et telle qu'une partie de cette couche supplémentaire définie par la tranchée fasse partie de la portion du capot se déformant lors de la gravure de la portion de matériau sacrificiel.

Le capot peut avoir une épaisseur inférieure ou égale à environ 10 µm, voire avantageusement inférieure ou égale à environ 5 µm.

De manière avantageuse, les étapes mises en oeuvre peuvent réaliser une encapsulation collective de plusieurs dispositifs microélectroniques disposés sur le substrat.

Lorsque l'une des couches du capot disposée contre la portion de matériau sacrificiel (appelée précédemment première couche) comporte au moins un matériau getter, le procédé peut comporter en outre, après le dépôt du matériau de bouchage, une étape d'activation thermique dudit matériau getter.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

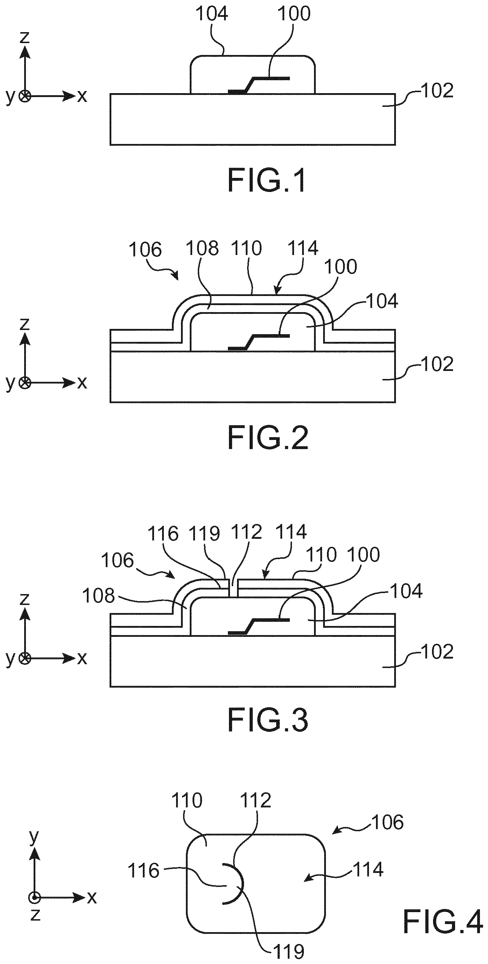

- les figures 1 à 12 représentent les étapes d'un procédé d'encapsulation d'un dispositif microélectronique, objet de la présente invention, selon un premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Les figures 1 à 12 représentent les étapes d'un procédé d'encapsulation d'un dispositif microélectronique 100 selon un premier mode de réalisation.

Le dispositif microélectronique 100, ici de type MEMS ou NEMS, est tout d'abord réalisé sur un substrat 102 par exemple en semi-conducteur tel que du silicium.

Une portion de matériau sacrificielle 104 est ensuite réalisée sur le substrat 102 telle qu'elle recouvre le dispositif 100 et que son volume corresponde sensiblement à celui d'une cavité dans laquelle le dispositif 100 est destiné à être encapsulé (figure 1). La portion 104 est par exemple obtenue par la mise en oeuvre d'un dépôt d'une couche de matériau sacrificiel, par exemple un polymère, dont l'épaisseur correspond à la hauteur souhaitée de la cavité dans laquelle le dispositif 100 est destiné à être encapsulé, généralement entre environ 1µm et 10 µm et par exemple égale à environ 5 µm. La couche de matériau sacrificiel est ensuite gravée afin que seule la portion 104 soit conservée sur le substrat 102.

Comme représenté sur la figure 2, un capot 106 recouvrant la portion 104 (et recouvrant également, dans l'exemple décrit ici, le substrat 102 autour de la portion 104) est ensuite réalisé. Ce capot 106 est formé par au moins deux couches ayant des contraintes résiduelles différentes. Dans le premier mode de réalisation décrit ici, le capot 106 comporte une première couche 108 de SiO₂ déposée par PECVD et dont l'épaisseur peut être comprise entre environ 1 µm et 2 µm. Cette première couche 108 présente une contrainte résiduelle en compression faible, par exemple comprise entre environ 20 MPa et 100 MPa. Le capot 106 comporte également une deuxième couche 110 correspondant ici à un empilement de plusieurs métaux déposés par PVD. A titre d'exemple, cet empilement de métaux peut comporter une sous-couche de titane d'épaisseur par exemple égale à environ 200 nm, et une couche de nickel d'épaisseur par exemple égale à environ 400 nm. La sous-couche de titane permet d'améliorer l'adhérence de la couche de nickel sur la portion 104. Le capot 106 comporte une face supérieure 114, formée ici par la face supérieure de la deuxième couche 110.

La deuxième couche de nickel possède une contrainte résiduelle en tension importante, par exemple comprise entre environ 100 MPa et 1000 MPa. La contrainte résiduelle en tension de la couche de nickel présente dans la deuxième couche 110 du capot 106 s'ajoute à la contrainte résiduelle en compression de la première couche 108 du capot 106. Ainsi, en considérant la contrainte résiduelle globale à laquelle le capot 106 est soumis, celle-ci va permettre d'obtenir, dans la suite du procédé, une déformation d'une portion du capot 106 vers l'extérieur de la cavité dans laquelle sera encapsulé le dispositif 100, c'est-à-dire dans une direction allant du dispositif 100 à cette portion du capot 106.

Les contraintes résiduelles des couches 108, 110 sont obtenues en raison des matériaux utilisés, mais peuvent également être accentuées ou réduites via les paramètres de dépôt (température, vitesse, puissance de plasma) utilisés lors du dépôt des couches 108, 110. Des traitements thermiques ultérieurs à ces dépôts peuvent également contribuer à l'obtention des contraintes résiduelles souhaitées.

Une tranchée 112 est ensuite réalisée à travers toute l'épaisseur du capot 106, au niveau de la face supérieure 114 du capot 106 (figure 3). La figure 4 représente une vue de dessus de la face supérieure 114 du capot 106 à travers lequel la tranchée 112 est réalisée selon un premier exemple de réalisation. Dans ce premier exemple de réalisation, le motif de la tranchée 112, au niveau de la face supérieure 114, correspond à une courbe, parexemple un arc de cercle. Une portion 116 du capot 106 correspondant au côté concave défini par la tranchée 112 forme ainsi une languette apte à se déformer et comportant une extrémité libre 119 apte à se déplacer vers l'extérieur de la structure d'encapsulation du dispositif 100. Avec une tranchée 112 dont le motif, au niveau de la face supérieure 114 du capot 106, correspond à un arc de cercle, la portion 116 a un motif correspondant à une partie d'un disque. Ainsi, dans l'exemple de la figure 4 où le motif de la tranchée 112 correspond sensiblement à un demi-cercle, la portion 116 a un motif correspondant sensiblement à un demi-disque.

Cette portion 116 peut avoir une longueur (qui correspond, sur l'exemple de la figure 4, à la dimension passant par la face supérieure 114 et qui est sensiblement perpendiculaire à la droite joignant les deux extrémités du motif de la tranchée 112) comprise entre environ 20 µm et 1 mm. En outre, la tranchée 112 peut avoir une largeur (correspondant à la plus petite dimension de la tranchée 112, au niveau de la face supérieure 114) de l'ordre d'un micron.

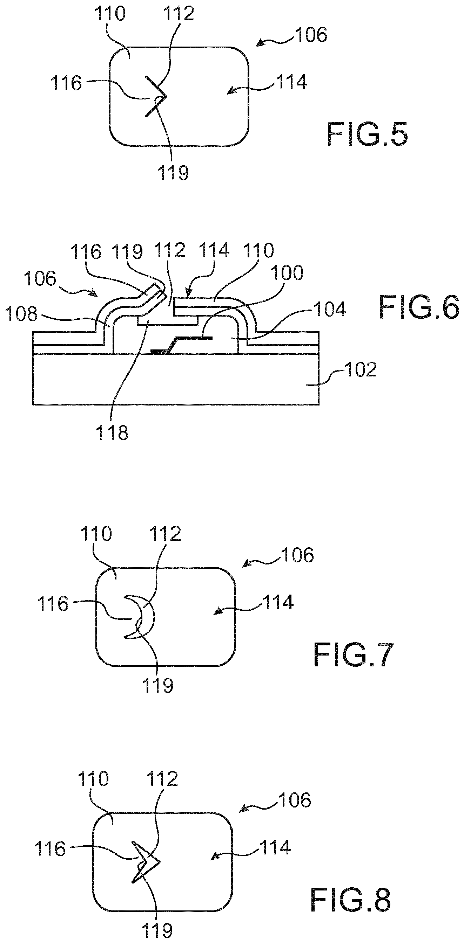

La figure 5 représente une vue de dessus de la face supérieure 114 du capot 106 traversé par la tranchée 112 réalisée selon un deuxième exemple de réalisation.

Dans ce deuxième exemple de réalisation, le motif de la tranchée 112, au niveau de la face supérieure 114, correspond à deux segments non parallèles l'un par rapport à l'autre, ou orientés selon deux directions différentes, et se joignant l'un à l'autre à une extrémité de chacun de deux segments. Avec un tel motif de la tranchée 112, la portion 116 a un motif, au niveau de la face supérieure 114 du capot 106, de forme triangulaire, l'extrémité libre de la portion 116 correspondant à la partie se trouvant à proximité du point de jonction des deux segments formant la tranchée 112.

De manière générale, le motif de tranchée 112, au niveau de la face supérieure 114 du capot 106, est tel qu'il définisse, dans le capot 106, une portion 116 comportant au moins une extrémité libre apte à se déplacer tel que la face supérieure de cette portion 116 se retrouve hors du plan de la face supérieure 114 du capot 106 sous l'effet de la contrainte résiduelle exercée par les matériaux du capot 106. Ce motif de la tranchée 112 peut comporter au moins une courbe et/ou au moins deux segments droits non parallèles l'un par rapport à l'autre et se croisant ou se rejoignant en un point d'intersection.

La portion 116 est ensuite libérée lorsqu'une partie de la portion 104 localisée sous la portion 116 est supprimée, par exemple par gravure sèche. Sur la figure 6, cette gravure forme un espace 118 localisé sous le capot 106, autour de la tranchée 112, libérant ainsi la portion 116 vis-à-vis de la portion 104. Du fait que la portion 116 n'est plus maintenue, les contraintes résiduelles présentes dans les matériaux du capot 106 la déforment et l'extrémité libre 119 de la portion 116 se déplace vers l'extérieur de la structure d'encapsulation du dispositif 100, c'est-à-dire dans une direction allant du dispositif 100 à la portion 116.

Cette déformation de la portion 116 augmente la section de passage des agents de gravure à travers la tranchée 112, ce qui permet d'augmenter les échanges entre l'espace sous le capot 106 et l'extérieur de la structure d'encapsulation du dispositif 100, et de réduire le temps nécessaire à la gravure de la portion 104. Les figures 7 et 8 représentent les mêmes vues que celles des figures 4 et 5, mais après la libération de la portion 116 vis-à-vis de la portion 104.

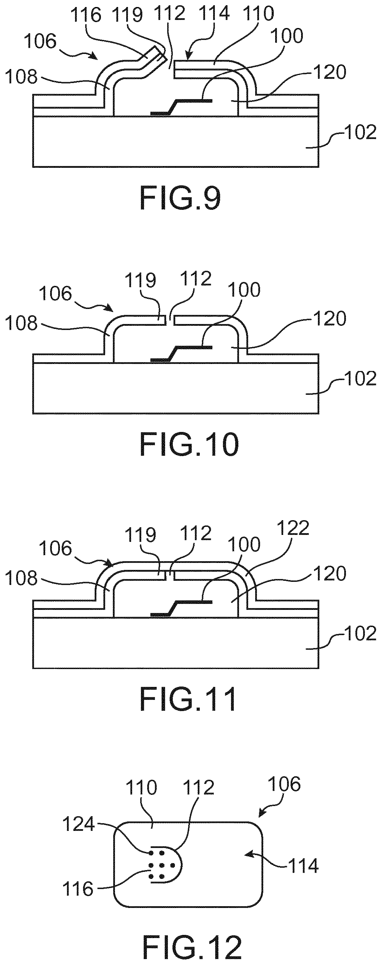

La gravure formant l'espace 118 est prolongée jusqu'à la suppression complète de la portion 104, formant une cavité 120 dans laquelle le dispositif 100 est disposé, cette cavité 120 étant délimitée par le substrat 102 et par le capot 106 (figure 9).

La ou les couches du capot 106 dont les contraintes résiduelles sont à l'origine de la contrainte mécanique déformant la portion 116, correspondant à la deuxième couche 110 dans le premier mode de réalisation décrit ici, est ensuite supprimée. La portion 116, qui n'est alors formée que de la ou des couches restantes à l'issue de cette gravure, ici la première couche 108, se relaxe alors sous sa forme la moins contrainte en revenant à sa position initiale (ou légèrement déformée selon les contraintes résiduelles dans les matériaux des couches restantes) correspondant sensiblement à celle lors du dépôt de la première couche 108 (figure 10). L'extrémité libre 119 de la portion 116 se retrouve alors sensiblement alignée avec le reste du capot 106. La tranchée 112 retrouve sa forme et ses dimensions initiales. La deuxième couche 110 peut être supprimée en mettant en oeuvre une gravure sèche. Dans le premier mode de réalisation décrit, la deuxième couche 110 correspond à un empilement d'une sous-couche de titane et d'une couche de nickel. Etant donné que la déformation de la portion 116 est due à la contrainte résiduelle en tension apportée par la couche de nickel, il est envisageable que seule la couche de nickel soit supprimée pour que la portion 116 retrouve sa position initiale. De manière générale, la gravure mise en oeuvre pour supprimer le ou les matériaux à l'origine de la déformation de la portion 116 est sélective vis-à-vis des matériaux présents dans la cavité 120 afin notamment d'éviter de dégrader le dispositif 100.

La tranchée 112 ayant retrouvé sa position initiale, la section de passage de la tranchée 112 entre la cavité 120 et l'extérieur de la structure d'encapsulation se retrouve réduite, ce qui permet de boucher la tranchée 112 sans risque de dépôt de matériau de bouchage dans la cavité 120, notamment sur le dispositif 100. Sur la figure 11, la tranchée 112 est bouchée en déposant par dépôt PVD une couche d'aluminium 122 sur l'ensemble du capot 106. En variante, le bouchage de la tranchée 112 peut être obtenu par un dépôt localisé d'un matériau de bouchage au-dessus de la tranchée 112.

Dans le mode de réalisation précédemment décrit, la gravure du matériau de la portion 104 permettant de libérer la portion 116 vis-à-vis du matériau sacrificiel est réalisée uniquement à travers la tranchée 112. Dans une variante, il est possible qu'en plus de la tranchée 112, des trous 124 de dimensions sensiblement similaires à la largeur de la tranchée 112 soient réalisés à travers le capot 106, avantageusement à travers la portion 116 comme sur l'exemple représenté sur la figure 12. Ainsi, l'élimination de la partie de la portion 104 libérant la portion 116 est obtenue plus rapidement, ce qui permet d'aboutir plus rapidement à la déformation de la portion 116 dans la position agrandissant les dimensions de la tranchée 112. Ces trous 124 contribuent également à la gravure de la portion 104 après que la portion 116 se déforme.

De tels trous 124 peuvent également être réalisés sur tout ou partie du capot 106 sans être nécessairement localisés au niveau de la portion 116.

Dans le premier mode de réalisation précédemment décrit, la déformation de la portion 116 est obtenue grâce aux contraintes résiduelles présentes dans les matériaux du capot 106, c'est-à-dire grâce aux contraintes mécaniques différentes entre les matériaux formant le capot 106. Dans un deuxième mode de réalisation, cette déformation de la portion 116 peut être obtenue du fait que les matériaux formant le capot 106 comportent des propriétés thermomécaniques différentes et que lors de la gravure de la portion 104, la portion 116 soit soumise à une température suffisante pour engendrer cette déformation.

Selon ce deuxième mode de réalisation et en reprenant la structure d'encapsulation précédemment décrite en liaison avec les figures 1 à 12, une déformation sensiblement similaire de la portion 116 peut être obtenue en réalisant le capot 106 tel que les couches 108 et 110 sont réalisées à partir de matériaux ayant des coefficients de dilatation thermique différents. La première couche 108 qui est déposée contre la portion sacrificielle 104 comporte dans ce cas un premier matériau ayant un coefficient de dilatation thermique supérieur à celui d'un deuxième matériau de la deuxième couche 110. Le choix des matériaux formant un tel capot 106 et des géométries de la portion 116 peut être réalisé suivant les instructions du document « Pyromètres à bilames » de J. Jouanneau, Techniques de l'Ingénieur, R 2540-1 à R 2540-10. Le tableau ci-dessous donne également plusieurs métaux pouvant être utilisés pour réaliser le capot 106, ainsi que les valeurs des coefficients de dilatation thermique α et des modules d'Young E de ces matériaux :

| Métal | α (10⁻⁶/°C) | E (GPa) |
|---|---|---|
| Al | 23,1 | 70 |
| Cu | 16,5 | 130 |
| Ni | 13,4 | 200 |
| Pt | 8,8 | 168 |
| Ti | 8,6 | 116 |
| Zr | 5,7 | 68 |

Par exemple, la première couche 108 peut comporter de l'aluminium et la deuxième couche 110 peut comporter du titane. Dans ce cas, lorsque la gravure du matériau sacrificiel de la portion 104 est mise en oeuvre à une température suffisamment élevée, généralement supérieur à environ 100°C et par exemple de l'ordre de 200°C, la portion 116 se déforme alors, augmentant ainsi la section de passage des agents de gravure du matériau sacrificiel. Une fois la gravure de la portion 104 achevée, la structure d'encapsulation est soumise à la température ambiante, permettant à la portion 116 de reprendre sa position initiale. Le bouchage de la tranchée 112 peut ensuite être réalisé. Lorsque le bouchage est réalisé à une température supérieure à celle déformant la portion 116, une des couches du capot 106 participant à la déformation de la portion 116 peut être supprimée avant la mise en oeuvre de ce bouchage afin d'éviter que la portion 116 soit déformée lors du bouchage. Lorsque le bouchage est réalisé à une température inférieure à celle déformant la portion 116, les couches du capot 106 peuvent être conservées. Lorsque la première couche 108 est en titane, ou plus généralement à base d'un matériau getter, compte tenu des propriétés getter de ce matériau, c'est-à-dire de son aptitude à adsorber et/ou absorber des molécules gazeuses telles que des molécules de H₂O, H₂, CO, CO₂, N₂, O₂, il est possible d'ajuster la pression finale dans la cavité 120 en activant le matériau de la première couche 108 par un chauffage à une température supérieure ou égale à sa température d'activation, généralement comprise entre environ 250°C et 400°C.

Les variantes précédemment décrites pour le premier mode de réalisation peuvent s'appliquer également au deuxième mode de réalisation.

Les deux modes de réalisation précédemment décrits peuvent être combinés l'un avec l'autre. Ainsi, le capot 106 peut être réalisé à partir de plusieurs couches de matériaux présentant des contraintes résiduelles différentes mais également des coefficients de dilatation thermique différents. Cela peut notamment être obtenu en réalisant chacune des première et deuxième couches 108, 110 comme un multicouche, ou un empilement de plusieurs matériaux différents. Ainsi, une déformation suffisante de la portion 116 peut être tout de même obtenue en combinant la déformation due à l'effet des contraintes résiduelles des matériaux en présence et celle due à l'effet de dilatation thermique de ces matériaux, et cela même si la température à laquelle la gravure du matériau sacrificiel de la portion 104 est limitée ou si les matériaux formant le capot 106 présentent des contraintes résiduelles ou des coefficients de dilatation thermique modérés.

Dans les deux modes de réalisation précédemment décrits, les propriétés mécaniques (contraintes résiduelles) ou thermomécaniques (coefficients de dilatation thermique) des matériaux formant le capot sont choisies pour que la portion 116 se déforme, lors de la gravure du matériau sacrificiel de la portion 104, telle que l'extrémité libre 119 de la portion 116 se déplace vers l'extérieur de la structure d'encapsulation. En variante, il est possible que les matériaux du capot 106 soient choisis tels que leurs propriétés mécaniques et/ou thermomécaniques déforment la portion 116, lors de la gravure du matériau sacrificiel de la portion 104, en déplaçant l'extrémité libre 119 de la portion 116 vers l'intérieur de la structure d'encapsulation ou l'intérieur de la cavité 120, c'est-à-dire dans une direction allant de cette portion 116 vers le dispositif 100.

Selon une variante des deux modes de réalisation précédemment décrits, il est possible que le capot comporte une ou plusieurs couches supplémentaires disposées au-dessus et/ou en dessous des couches ayant des propriétés mécaniques et/ou thermomécaniques différentes. Dans ce cas, la tranchée 112 est réalisée telle qu'elle traverse également cette ou ces couches supplémentaires. De plus, la ou les épaisseurs de cette ou ces couches supplémentaires ainsi que la nature du ou des matériaux de cette ou ces couches supplémentaires sont telles que la ou les parties de cette ou ces couches supplémentaires disposées contre la portion 116 puissent se déformer en suivant la déformation de la portion 116 afin que la section de passage des agents de gravure à travers la tranchée 112 augmente bien lors de la déformation de la portion 116.

## Revendications

1. Procédé d'encapsulation d'au moins un dispositif microélectronique (100), comportant au moins les étapes suivantes :
- réalisation d'au moins une portion de matériau sacrificiel (104) recouvrant au moins le dispositif microélectronique (100) ;
- réalisation d'au moins un capot (106) recouvrant au moins la portion de matériau sacrificiel (104), le capot (106) comportant au moins deux couches (108, 110) superposées de matériaux distincts et ayant des contraintes résiduelles différentes et/ou des coefficients de dilatation thermique différents ;
- gravure, à travers le capot (106), d'au moins une tranchée (112) dont le motif, au niveau d'une face supérieure (114) du capot (106), comporte au moins une courbe et/ou au moins deux segments droits non parallèles l'un par rapport à l'autre et se rejoignant en un point d'intersection ;
- gravure de la portion de matériau sacrificiel (104) à travers la tranchée (112) telle que, lors de cette gravure, une portion (116) du capot (106) définie par la tranchée (112) se déforme sous l'effet d'une contrainte mécanique engendrée par les contraintes résiduelles et/ou une dilatation thermique desdites au moins deux couches (108, 110) du capot (106) et augmente les dimensions de la tranchée (112) ;
- suppression au moins partielle de la contrainte mécanique, obtenue soit en retirant au moins une partie d'une deuxième (110) desdites au moins deux couches (108, 110) du capot (106) qui est telle qu'une première (108) des deux couches (108, 110) du capot (106) soit disposée entre la portion de matériau sacrificiel (104) et la deuxième (110) des deux couches (108, 110) du capot (106), soit en arrêtant de soumettre lesdites au moins deux couches (108, 110) du capot (106) à une température engendrant la déformation de la portion (116) du capot (106) ;
- dépôt d'au moins un matériau de bouchage (122) au moins sur la tranchée (112).

2. Procédé selon la revendication 1, dans lequel, lors de la gravure de la portion de matériau sacrificiel (104), la déformation de la portion (116) du capot (106) est telle qu'une extrémité libre (119) de la portion (116) du capot (106) se déplace hors d'une cavité (120) formée par la gravure de la portion de matériau sacrificiel (104).

3. Procédé selon l'une des revendications précédentes, dans lequel la première (108) des deux couches (108, 110) du capot (106) comporte une contrainte résiduelle de valeur et/ou de type différent de la contrainte résiduelle de la deuxième (110) des deux couches (108, 110) du capot (106).

4. Procédé selon la revendication 3, dans lequel la première (108) des deux couches (108, 110) du capot (106) comporte une contrainte résiduelle en compression et la deuxième (110) des deux couches (108, 110) du capot (106) comporte une contrainte résiduelle en tension.

5. Procédé selon l'une des revendications 3 ou 4, dans lequel la première (108) des deux couches (108, 110) du capot (106) comporte du SiO₂ et la deuxième (110) des deux couches (108, 110) du capot (106) comporte du nickel.

6. Procédé selon l'une des revendications 3 à 5, dans lequel la deuxième (110) des deux couches (108, 110) du capot comporte un empilement d'une sous-couche comprenant du titane recouvrant la première (108) des deux couches (108, 110) du capot (106) et d'une couche de nickel recouvrant la sous-couche.

7. Procédé selon l'une des revendications 3 à 6, dans lequel la suppression au moins partielle de la contrainte mécanique déformant la portion (116) du capot (106) comporte la mise en oeuvre d'un retrait d'au moins une partie de la deuxième (110) des deux couches (108, 110) du capot (106).

8. Procédé selon l'une des revendications précédentes, dans lequel une première (108) des deux couches (108, 110) du capot (106), disposée entre la portion de matériau sacrificiel (104) et une deuxième (110) des deux couches (108, 110) du capot (106), comporte un coefficient de dilatation thermique supérieur à celui de la deuxième (110) des deux couches (108, 110) du capot (106), et dans lequel la gravure de la portion de matériau sacrificiel (104) est mise en oeuvre à une température engendrant une déformation de la portion (116) du capot (106) due à la dilatation thermique des deux couches (108, 110).

9. Procédé selon la revendication 8, dans lequel la première (108) des deux couches (108, 110) du capot (106) comporte de l'aluminium et la deuxième (110) des deux couches (108, 110) du capot (106) comporte du titane.

10. Procédé selon l'une des revendications 8 ou 9, dans lequel le dépôt du matériau de bouchage (122) est mis en oeuvre à température ambiante.

11. Procédé selon l'une des revendications précédentes, dans lequel l'étape de gravure de la tranchée (112) à travers le capot (106) grave également des trous (124) à travers le capot (106) et ayant au moins une dimension sensiblement similaire à une largeur de la tranchée (112).

12. Procédé selon la revendication 11, dans lequel les trous (124) traversent la portion (116) du capot (106) se déformant lors de la gravure de la portion de matériau sacrificiel (104).

13. Procédé selon l'une des revendications précédentes, dans lequel le capot (106) comporte en outre au moins une couche supplémentaire à travers laquelle au moins la tranchée (112) est gravée et telle qu'une partie de cette couche supplémentaire définie par la tranchée (112) fasse partie de la portion (116) du capot (106) se déformant lors de la gravure de la portion de matériau sacrificiel (104).

14. Procédé selon l'une des revendications précédentes, dans lequel le capot (106) a une épaisseur inférieure ou égale à environ 10 µm.

15. Procédé selon l'une des revendications précédentes, dans lequel les étapes mises en oeuvre réalisent une encapsulation collective de plusieurs dispositifs microélectroniques (100) disposés sur un même substrat (102).

16. Procédé selon l'une des revendications précédentes, dans lequel, lorsque l'une des couches (108, 110) du capot (106) disposée contre la portion de matériau sacrificiel (104) comporte au moins un matériau getter, le procédé comporte en outre, après le dépôt du matériau de bouchage (122), une étape d'activation thermique dudit matériau getter.

## Patentansprüche

1. Verfahren zum Verkapseln wenigstens einer mikroelektronischen Vorrichtung (100), umfassend wenigstens die folgenden Schritte:
- Bilden von wenigstens einem Abschnitt aus einem Opfermaterial (104), welcher wenigstens die mikroelektronische Vorrichtung (100) bedeckt;
- Bilden wenigstens einer Haube (106), welche wenigstens den Abschnitt aus Opfermaterial (104) bedeckt, wobei die Haube (106) wenigstens zwei überlagerte Schichten (108, 110) aus verschiedenen Materialien umfasst, welche unterschiedliche Restspannungen und/oder unterschiedliche thermische Ausdehnungskoeffizienten aufweisen;
- Ätzen wenigstens eines Grabens (112) durch die Haube (106) hindurch, wobei das Motiv auf dem Niveau einer oberen Fläche (114) der Haube (106) wenigstens eine Kurve und/oder wenigstens zwei gerade Segmente, welche nicht parallel zueinander sind und sich in einem Schnittpunkt vereinen, umfasst;
- Ätzen des Abschnitts aus Opfermaterial (104) durch den Graben (112) hindurch derart, dass während dieses Ätzens ein Abschnitt (116) der Haube (106), welcher durch den Graben (112) definiert ist, sich unter der Wirkung einer mechanischen Spannung verformt, welche durch die Restspannungen und/oder eine thermische Ausdehnung der wenigstens zwei Schichten (108, 110) der Haube (106) hervorgerufen wird und die Abmessungen des Grabens (112) vergrößert;
- wenigstens teilweises Beseitigen der mechanischen Spannung, welches durch Abtragen wenigstens einen Teils der zweiten (110) der wenigstens zwei Schichten (108, 110) der Haube (106) erreicht wird, so dass eine erste (108) der beiden Schichten (108, 110) der Haube (106) zwischen dem Abschnitt aus Opfermaterial (104) und der zweiten (110) der beiden Schichten (108, 110) der Haube (106) angeordnet ist, indem das Aussetzen der wenigstens zwei Schichten (108, 110) der Haube (106) einer Temperatur beendet wird, welche die Verformung des Abschnitts (116) der Haube (106) hervorruft;
- Ablagern von wenigstens einem Füllmittel (122) wenigstens auf dem Graben (112).

2. Verfahren nach Anspruch 1, wobei während des Ätzens des Abschnitts aus Opfermaterial (104) die Verformung des Abschnitts (116) der Haube (106) derart ist, dass ein freies Ende (119) des Abschnitts (116) der Haube (106) außerhalb eines Hohlraums (120) verlagert werden, welcher durch das Ätzen des Abschnitts aus Opfermaterial (104) gebildet wird.

3. Verfahren nach einem der vorhergehenden Ansprüche, wobei die erste (108) der beiden Schichten (108, 110) der Haube (106) eine Restspannung von einem Wert und/oder Typ umfasst, welche/r verschieden von der Restspannung der zweiten (110) der beiden Schichten (108, 110) der Haube (106) ist.

4. Verfahren nach Anspruch 3, wobei die erste (108) der beiden Schichten (108, 110) der Haube (106) eine Restspannung auf Kompression umfasst und die zweite (110) der beiden Schichten (108, 110) der Haube (106) eine Restspannung auf Zug umfasst.

5. Verfahren nach einem der Ansprüche 3 oder 4, wobei die erste (108) der beiden Schichten (108, 110) der Haube (106) SiO₂ umfasst und die zweite (110) der beiden Schichten (108, 110) der Haube (106) Nickel umfasst.

6. Verfahren nach einem der Ansprüche 3 bis 5, wobei die zweite (110) der beiden Schichten (108, 110) der Haube einen Stapel aus einer Unterschicht umfasst, welche Titan umfasst, die erste (108) der beiden Schichten (108, 110) der Haube (106) bedeckend, und eine Schicht aus Nickel, welche die Unterschicht bedeckt.

7. Verfahren nach einem der Ansprüche 3 bis 6, wobei das wenigstens teilweise Beseitigen der mechanischen Spannung, welche den Abschnitt (116) der Haube (106) verformt, ein Durchführen eines Abnehmens von wenigstens einem Teil der zweiten (110) der beiden Schichten (108, 110) der Haube (106) umfasst.

8. Verfahren nach einem der vorhergehenden Ansprüche, wobei eine erste (108) der beiden Schichten (108, 110) der Haube (106), welche zwischen dem Abschnitt aus Opfermaterial (104) und einer zweiten (110) der beiden Schichten (108, 110) der Haube (106) angeordnet ist, einen thermischen Ausdehnungskoeffizienten umfasst, welcher größer als derjenige der zweiten (110) der beiden Schichten (108, 110) der Haube (106) ist, und wobei das Ätzen des Abschnitts aus Opfermaterial (104) bei einer Temperatur durchgeführt wird, welche eine Verformung des Abschnitts (116) der Haube (106) aufgrund der thermischen Ausdehnung der beiden Schichten (108, 110) hervorruft.

9. Verfahren nach Anspruch 8, wobei die erste (108) der beiden Schichten (108, 110) der Haube (106) Aluminium umfasst und die zweite (110) der beiden Schichten (108, 110) der Haube (106) Titan umfasst.

10. Verfahren nach einem der Ansprüche 8 oder 9, wobei das Ablagern des Füllmaterials (122) bei einer Umgebungstemperatur durchgeführt wird.

11. Verfahren nach einem der vorhergehenden Ansprüche, wobei der Schritt des Ätzens des Grabens (112) durch die Haube (106) hindurch ebenfalls Löcher (124) durch die Haube (106) hindurch und mit einer Ausdehnung im Wesentlichen gleich zu einer Länge des Grabens (112) ätzt.

12. Verfahren nach Anspruch 11, wobei die Löcher (124), welche den Abschnitt (116) der Haube (106) durchqueren, sich während des Ätzens des Abschnitts des Opfermaterials (104) verformen.

13. Verfahren nach einem der vorhergehenden Ansprüche, wobei die Haube (106) ferner wenigstens eine zusätzliche Schicht umfasst, durch welche hindurch wenigstens der Graben (112) geätzt ist, und derart, dass ein Teil dieser zusätzlichen Schicht, welcher durch den Graben (112) definiert ist, einen Teil des Abschnitts (116) der Haube (106) bildet, welcher sich während des Ätzens des Abschnitts des Opfermaterials (104) verformt.

14. Verfahren nach einem der vorhergehenden Ansprüche, wobei die Haube (106) eine Dicke aufweist, welche kleiner oder gleich etwa 10 µm ist.

15. Verfahren nach einem der vorhergehenden Ansprüche, wobei die durchgeführten Schritte eine gemeinsame Verkapselung von mehreren mikroelektronischen Vorrichtungen (100) hervorrufen, welche an einem gleichen Substrat (102) angeordnet sind.

16. Verfahren nach einem der vorhergehenden Ansprüche, wobei wenn die eine der Schichten (108, 110) der Haube (106), welche gegen den Abschnitt des Opfermaterials (104) abgelagert wird, wenigstens ein Gettermaterial umfasst, das Verfahren ferner nach dem Ablagern des Füllmaterials (122) einen Schritt einer thermischen Aktivierung des Gettermaterials umfasst.

## Claims

1. Method for encapsulating at least one microelectronic device (100), comprising at least the following steps :
- producing at least one portion of sacrificial material (104) covering at least the microelectronic device (100);
- producing at least one cover (106) covering at least the portion of sacrificial material (104), the cover (106) comprising at least two superimposed layers (108, 110) of separate materials and having different residual stresses and/or different coefficients of thermal expansion;
- etching, through the cover (106), of at least one trench (112) of which the pattern, at an upper face (114) of the cover (106), comprises at least one curve and/or at least two straight segments non-parallel with respect to each other and joining up at an intersection point;
- etching of the portion of sacrificial material (104) through the trench (112) such that, during this etching, a portion (116) of the cover (106) defined by the trench (112) deforms under the effect of a mechanical stress generated by the residual stresses and/or a thermal expansion of said at least two layers (108,110) of the cover (106) and increases the dimensions of the trench (112);
- at least partial elimination of the mechanical stress, obtained either by removing at least a part of a second (110) of said at least two layers (108, 110) of the cover (106) which is such that a first (108) of the two layers (108, 110) of the cover (106) is arranged between the portion of sacrificial material (104) and the second (110) of the two layers (108, 110) of the cover (106), or by stopping subjecting said at least two layers (108, 110) of the cover (106) to a temperature generating a deformation of the portion (116) of the cover (106) ;
- depositing at least one sealing material (122) at least on the trench (112).

2. Method according to claim 1, in which, during the etching of the portion of sacrificial material (104), the deformation of the portion (116) of the cover (106) is such that a free end (119) of the portion (116) of the cover (106) moves outside a cavity (120) formed by the etching of the portion of sacrificial material (104).

3. Method according to one of previous claims, in which the first (108) of the two layers (108, 110) of the cover (106) comprises a residual stress of different value and/or type to the residual stress of the second (110) of the two layers (108, 110) of the cover (106).

4. Method according to claim 3, in which the first (108) of the two layers (108,110) of the cover (106) comprises a residual compressive stress and the second (110) of the two layers (108, 110) of the cover (106) comprises a residual tensile stress.

5. Method according to one of claims 3 or 4, in which the first (108) of the two layers (108, 110) of the cover (106) comprises SiO₂ and the second (110) of the two layers (108, 110) of the cover (106) comprises nickel.

6. Method according to one of claims 3 to 5, in which the second (110) of the two layers (108, 110) of the cover comprises a stack of a sub-layer including titanium covering the first (108) of the two layers (108, 110) of the cover (106) and a layer of nickel covering the sub-layer.

7. Method according to one of claims 3 to 6, in which the at least partial elimination of the mechanical stress deforming the portion (116) of the cover (106) comprises the implementation of a removal of a least one part of the second (110) of the two layers (108, 110) of the cover (106).

8. Method according to one of previous claims, in which a first (108) of the two layers (108,110) of the cover (106), arranged between the portion of sacrificial material (104) and a second (110) of the two layers (108,110) of the cover (106), comprises a coefficient of thermal expansion greater than that of the second (110) of the two layers (108, 110) of the cover (106), and in which the etching of the portion of sacrificial material (104) is implemented at a temperature generating a deformation of the portion (116) of the cover (106) due to the thermal expansion of the two layers (108, 110).

9. Method according to claim 8, in which the first (108) of the two layers (108, 110) of the cover (106) comprises aluminium and the second (110) of the two layers (108, 110) of the cover (106) comprises titanium.

10. Method according to one of claims 8 or 9, in which the deposition of the sealing material (122) is implemented at ambient temperature.

11. Method according to one of previous claims, in which the step of etching of the trench (112) through the cover (106) also etches holes (124) through the cover (106) and having at least one dimension substantially similar to a width of the trench (112).

12. Method according to claim 11, in which the holes (124) cross the portion (116) of the cover (106) that deforms during the etching of the portion of sacrificial material (104).

13. Method according to one of previous claims, in which the cover (106) further comprises at least one additional layer through which at least the trench (112) is etched and such that a part of this additional layer defined by the trench (112) forms part of the portion (116) of the cover (106) that deforms during the etching of the portion of sacrificial material (104).

14. Method according to one of previous claims, in which the cover (106) has a thickness less than or equal to around 10 µm.

15. Method according to one of previous claims, in which the steps implemented produce a collective encapsulation of several microelectronic devices (100) arranged on a same substrate (102).

16. Method according to one of previous claims, in which, when one of the layers (108, 110) of the cover (106) arranged against the portion of sacrificial material (104) comprises at least one getter material, the method further comprises, after the deposition of the sealing material (122), a step of thermal activation of said getter material.
